Europäisches Patentamt

European Patent Office

Office européen des brevets

(19)

(11) EP 0 750 782 B1

## (12) FASCICULE DE BREVET EUROPEEN

(45) Date de publication et mention
de la délivrance du brevet:
**11.11.1998 Bulletin 1998/46**

(21) Numéro de dépôt: **95913203.6**

(22) Date de dépôt: **16.03.1995**

(51) Int Cl.6: **G11C 27/02**

(86) Numéro de dépôt international:
**PCT/FR95/00317**

(87) Numéro de publication internationale:
**WO 95/25329 (21.09.1995 Gazette 1995/40)**

### (54) ECHANTILLONNEUR-BLOQUEUR DIFFERENTIEL RAPIDE

SCHNELLE DIFFERENZIALE ABTAST- UND HALTESCHALTUNG

FAST DIFFERENTIAL SAMPLE-AND-HOLD CIRCUIT

(84) Etats contractants désignés:
**DE FR GB IT NL**

(30) Priorité: **16.03.1994 FR 9403086**

(43) Date de publication de la demande:
**02.01.1997 Bulletin 1997/01**

(73) Titulaire: **THOMSON-CSF SEMICONDUCTEURS SPECIFIQUES**
**75008 Paris (FR)**

(72) Inventeur: **GRASSET, Jean-Charles**
**F-92402 Courbevoie cédex (FR)**

(74) Mandataire: **Guérin, Michel**
**Thomson-CSF Propriété Intellectuelle,**
**13, Avenue du Président Salvador Allende**
**94117 Arcueil Cédex (FR)**

(56) Documents cités:
**EP-A- 0 394 506          EP-A- 0 394 507**

- **IEEE JOURNAL OF SOLID-STATE CIRCUITS., vol.25, no.6, Décembre 1990, NEW YORK US pages 1339 - 1346 PETSCHACHER ET AL 'A 10-b 75-MSPS subranging A/D converter with integrated sample and hold'**

## Description

L'invention concerne les circuits d'échantillonnage et de blocage de signaux électriques analogiques, et plus particulièrement les circuits d'échantillonnage et de blocage rapides.

De tels circuits d'échantillonnage et de blocage, qui seront par la suite appelés échantillonneurs-bloqueurs, sont utilisés, par exemple, dans le traitement des signaux issus de capteurs photosensibles à transfert de charges.

De façon plus générale, l'invention concerne aussi les échantillonneurs-bloqueurs utilisés dans tout autre type d'application.

La réalisation d'échantillonneurs-bloqueurs rapides passe pratiquement par la mise en oeuvre d'architectures en boucle ouverte, de manière à exploiter au mieux les caractéristiques intrinsèques des technologies utilisées. Il en est ainsi, par exemple, de la technologie à transistors bipolaires NPN rapides.

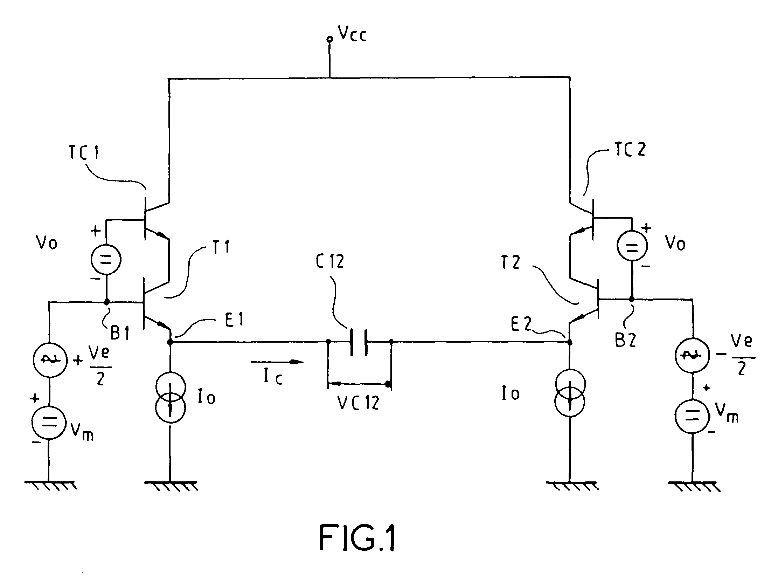

Selon l'art antérieur, tel que décrit par exemple dans le brevet EP-A-0 394 506, il est connu, parmi les échantillonneurs-bloqueurs rapides, des architectures telles que celle représentée en figure 1. C'est une structure de type différentiel dans laquelle les transistors NPN T1 et T2 jouent le rôle d'interrupteurs.

Les signaux d'entrée sont appliqués sur les bases B1 et B2 des transistors respectifs T1 et T2 et le signal de sortie est récupéré entre les émetteurs E1 et E2 des transistors T1 et T2.

Une capacité C12 relie les émetteurs E1 et E2. Le circuit représenté en figure 1 fonctionne selon deux régimes. L'un des régimes est le régime suiveur. Chacun des deux transistors T1 et T2, polarisé à l'aide d'un générateur de courant Io reliant son émetteur à la masse du circuit, est alors passant. L'autre régime est le régime bloqué. Les sources de courant Io sont alors coupées et les transistors T1 et T2 sont bloqués.

En régime suiveur, si l'on note Vm la tension de polarisation de mode commun présente sur chacune des bases B1 et B2, + Ve/2 le signal variable d'entrée appliqué sur la base B1 et - Ve/2 le signal variable d'entrée appliqué sur la base B2, la tension totale VB1 appliquée sur la base B1 s'écrit :

$$VB1 = Vm + \frac{Ve}{2}$$

et la tension totale VB2 appliquée sur la base B2 :

$$VB2 = Vm - \frac{Ve}{2}$$

La capacité mémoire C12 de l'échantillonneur-bloqueur relie les émetteurs E1 et E2.

La tension VC12 qui existe aux bornes de cette capacité, s'écrit donc:

$$VC12 = VE1 - VE2$$

où VE1 et VE2 représentent les tensions appliquées respectivement sur les émetteurs E1 et E2.

Or, il est connu que :

$$VB1 = VBE1 + VE1$$

et

$$VB2 = VBE2 + VE2,$$

où VBE1 et VBE2 représentent respectivement les tensions base-émetteur des transistors T1 et T2.

La tension VC12 peut alors s'écrire :

$$VC12 = VB1 - VB2 + (VBE2 - VBE1).$$

soit :

$$VC12 = Ve + (VBE2 - VBE1).$$

En régime dit de "petit signal", c'est-à-dire lorsque l'amplitude du signal variable d'entrée est très petite devant l'amplitude des tensions continues de polarisation, il est connu de l'homme de l'art que le terme VBE2 - VBE1 peut être négligé. Par contre, dès que l'amplitude du signal variable d'entrée ne peut plus être considérée comme petite devant l'amplitude des tensions continues, ce terme n'est plus négligeable.

Le circuit est alors dit non linéaire.

Dans la pratique, trois causes sont à l'origine de cette non-linéarité.

Une première cause est l'effet Early qui apparaît dans les transistors T1 et T2. La tension VBE de chaque transistor varie alors sous l'effet de la modulation du courant de saturation de la jonction base-émetteur du transistor. Cette première cause de non-linéarité trouve sa solution en réalisant un montage connu par l'homme de l'art sous le nom de montage "cascode". Comme représenté en figure 1, des transistors TC1 et TC2, convenablement polarisés par les tensions Vo appliquées sur leur base, sont alors montés en série avec les transistors respectifs T1 et T2.

Une deuxième cause réside en ce que les transistors T1 et T2 ne fonctionnent pas à un courant constant mais à un courant dynamique modulé par le courant Ic qui parcourt la capacité C12. Comme cela est connu de l'homme de l'art, il vient alors :

$$VBE2 - VBE1 = Ut \times Ln\,[(Io + Ic)/(Io - Ic)]$$

avec

$$I_c = C12 \frac{dVC12}{dt}$$

où Ut est le potentiel thermodynamique (Ut = 26 millivolts à la température de 300 degrés Kelvin). Dans l'équation précédente Ln[X] est la notation choisie pour représenter le logarithme népérien de la grandeur X.

Une troisième cause est due à la combinaison des première et deuxième causes qui se conjuguent et rendent les courants de base de T1 et T2 variables de façon non linéaire (modulation du courant de base par modulation de Ic, modulation du gain du transistor par l'effet Early).

Selon l'art antérieur, la deuxième cause est atténuée en augmentant la valeur du courant Io. Ainsi, l'influence du courant Ic se trouve-t-elle diminuée.

Ce procédé présente de nombreux inconvénients.

L'accroissement de courant Io entraîne une augmentation de la puissance consommée par le circuit. D'autre part, cet accroissement de courant implique nécessairement un accroissement de la géométrie des transistors T1 et T2 afin que ces derniers travaillent avec des densités de courant raisonnables. La capacité base-émetteur de chacun des transistors T1 ou T2 se trouve augmentée. En régime bloqué, une fraction non négligeable de la tension variable appliquée sur la base des transistors T1 et T2 est alors susceptible de se retrouver sur l'émetteur de ces transistors. Une tension parasite de sortie est alors détectée aux bornes de la capacité C12.

L'invention ne présente pas ces inconvénients.

L'invention a pour objet un échantillonneur-bloqueur différentiel comprenant un premier et un second transistors (T1 et T2) commandés de façon à être rendus passants ou bloqués, le signal de sortie de l'échantillonneur-bloqueur étant récupéré aux bornes d'une capacité de sortie (C12) reliant les émetteurs (E1, E2) desdits transistors, caractérisé en ce qu'il comprend des moyens pour rendre constant le courant (Io) qui traverse les transistors à l'état passant, pendant les phases d'échantillonnage, malgré les variations de courant dans la capacité de sortie.

Les caractéristiques et avantages de l'invention apparaîtront à la lecture d'un mode de réalisation préférentiel fait avec référence aux figures ci-annexées dans lesquelles :

- la figure 1 représente un échantillonneur-bloqueur selon l'art antérieur ;
- la figure 2 représente le schéma de principe d'un échantillonneur-bloqueur selon l'invention ;
- les figures 3a et 3b représentent le schéma d'un échantillonneur-bloqueur selon le mode de réalisation préférentiel de l'invention ;
- la figure 4 représente le schéma de l'échantillonneur-bloqueur de la figure 3 dans lequel a été apporté un premier perfectionnement;
- la figure 5 représente le schéma de l'échantillonneur-bloqueur de la figure 3 dans lequel a été apporté un deuxième perfectionnement;
- la figure 6 représente une vue de détail du circuit représenté en figure 5.

Sur toutes les figures, les mêmes repères désignent les mêmes éléments.

La figure 1 a été décrite précédemment, il est donc inutile d'y revenir.

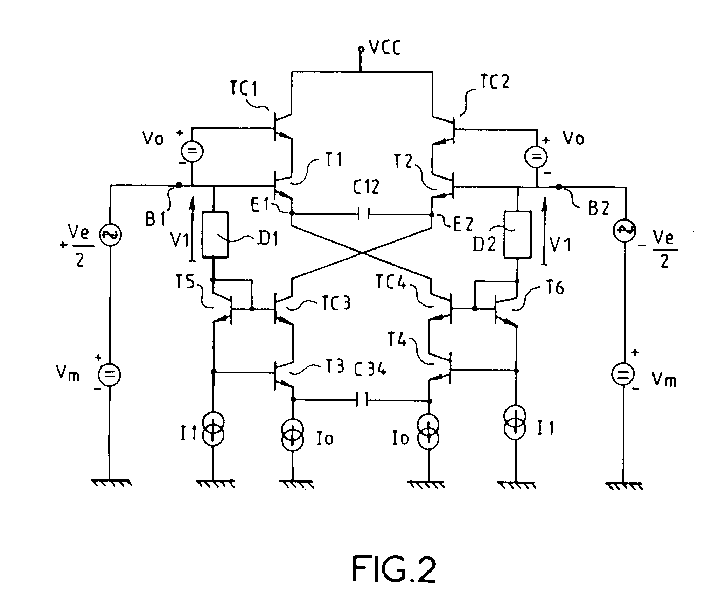

La figure 2 représente le schéma de principe d'un échantillonneur-bloqueur selon l'invention.

Cet échantillonneur-bloqueur est construit à partir d'une structure différentielle. Les signaux d'entrée $+\frac{Ve}{2}$ et $\frac{Ve}{2}$ sont appliqués sur les bases B1 et B2 des transistors respectifs T1 et T2 et le signal de sortie est récupéré aux bornes de la capacité C12 qui relie les émetteurs E1 et E2 de T1 et T2.

De même que précédemment, deux transistors TC1 et TC2, convenablement polarisés, sont montés en série avec les transistors respectifs T1 et T2 de façon à constituer un montage "cascode".

Une tension de polarisation de mode commun Vm est appliquée à chacune des deux bases B1 et B2.

Selon l'invention, les deux transistors T1 et T2 sont alimentés par deux générateurs de courant dynamiques. Ces générateurs de courant dynamiques sont intégrés au circuit de façon à fournir des courants dont les variations rendent constant le courant qui parcourt les transistors T1 et T2. Un premier générateur de courant dynamique est associé au transistor T1. Il est constitué d'un transistor T4 dont la base reçoit un signal variant au rythme du signal appliqué à la base du transistor T2 et dont l'émetteur est relié à un générateur de courant constant Io. Un second générateur de courant dynamique est associé au transistor T2. Il est constitué d'un transistor T3 dont la base reçoit un signal variant au rythme du signal appliqué à la base du transistor T1 et dont l'émetteur est relié à un générateur de courant constant de même valeur Io.

De façon préférentielle, les transistors T3 et T4 sont respectivement reliés aux transistors T2 et T1 par l'intermédiaire des transistors TC3 et TC4 qui constituent des montages "cascode". Ainsi, le collecteur du transistor T3 est-il relié à l'émetteur du transistor TC3 dont le collecteur est relié à l'émetteur du transistor T2. De même, le collecteur du transistor T4 est-il relié à l'émetteur du transistor TC4 dont le collecteur est relié à l'émetteur du transistor T1.

Une capacité C34, préférentiellement de même valeur que la capacité mémoire C12, relie les émetteurs des transistors T3 et T4. Les variations de courant $\Delta I$ qui apparaissent dans la capacité C34 sont alors égales en amplitude, mais de signe opposé, à celles qui apparaissent dans la capacité C12 et les transistors T1 et T2 sont traversés par un courant constant sensiblement égal à Io.

Comme cela apparaît ci-dessus, les générateurs de courant sont modulés par les signaux variables appliqués sur les entrées B1 et B2 de l'échantillonneur-bloqueur.

De façon à empêcher la saturation des transistors TC3 et TC4, la tension de mode commun appliquée à ces transistors est décalée d'une tension V1.

Ainsi, un dipôle D1 relie-t-il la base B1 du transistor T1 à la base B3 du transistor TC3 et un dipôle D2, de préférence identique au dipôle D1, relie-t-il la base B2 du transistor T2 à la base B4 du transistor TC4. Les dipôles D1 et D2 peuvent être réalisés à l'aide d'une résistance ou d'un ensemble de diodes montées en série comme cela sera précisé ultérieurement.

Afin d'éviter la saturation des transistors T3 et T4, les tensions continues appliquées sur les bases des transistors TC3 et T3 sont décalées de même que les tensions continues appliquées sur les bases des transistors TC4 et T4. A cette fin, un transistor T5 a son collecteur et sa base reliés à la base du transistor TC3 et son émetteur relié à la base du transistor T3.

De même, un transistor T6 a son collecteur et sa base reliés à la base du transistor TC4 et son émetteur relié à la base du transistor T4.

Un générateur de courant I1 relie la base de chacun des transistors T3 et T4 à la masse du dispositif, fixant ainsi la valeur du courant qui traverse chacun des dipôles D1 et D2.

Un avantage de l'invention est de ne faire appel à aucune réaction (positive ou négative). Ainsi, les circuits permettant, selon l'invention, d'annuler la modulation des courants qui traversent les transistors T1 et T2 n'apportent-ils aucune limitation en vitesse et en stabilité.

Un autre avantage de l'invention est l'augmentation sensible de l'impédance dynamique d'entrée de l'échantillonneur-bloqueur due à l'affaiblissement des variations du courant de base du circuit. Il s'ensuit qu'il est alors inutile d'amener le signal à l'entrée de l'échantillonneur-bloqueur à très basse impédance.

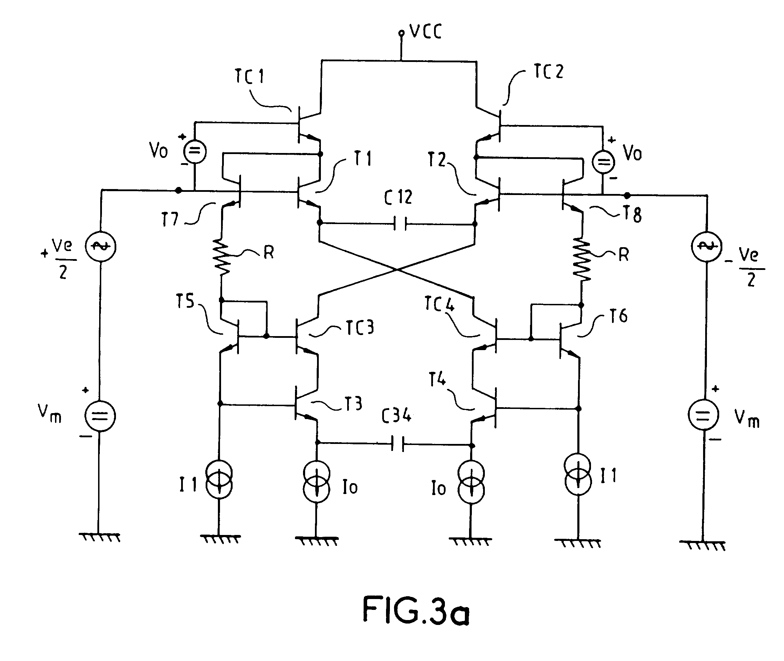

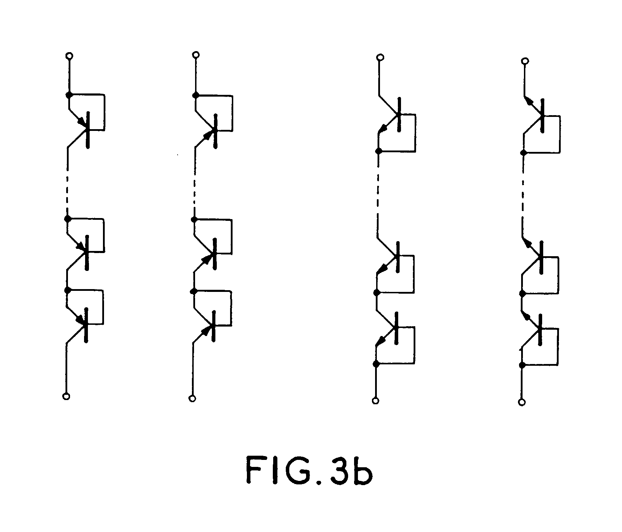

La figure 3a représente le schéma d'un échantillonneur-bloqueur selon le mode de réalisation préférentiel de l'invention.

On retrouve sur la figure 3a tous les éléments constitutifs du circuit représenté en figure 2. Selon le circuit de la figure 3a, le courant I1 du générateur de courant qui relie la base du transistor T3 à la masse circule, en quasi-totalité, dans le transistor T7 dont la base est reliée à la base du transistor T1, dont le collecteur est relié à l'émetteur du transistor TC1 et dont l'émetteur est relié à la bome du dipôle D1 précédemment reliée (cf. figure 2) à la base du transistor T1.

De même, le courant II du générateur de courant qui relie la base du transistor T4 à la masse circule, en quasi-totalité, dans le transistor T8 dont la base est reliée à la base du transistor T2, dont le collecteur est relié à l'émetteur du transistor TC2 et dont l'émetteur est relié à la borne du dipôle D2 précédemment reliée (cf. figure 2) à la base du transistor T2.

Un tel dispositif présente l'avantage d'éviter que les générateurs qui délivrent les tensions Vm et Ve n'aient à débiter la quasi-totalité du courant I1.

Sur la figure 3a, les dipôles D1 et D2 sont réalisés à l'aide d'une résistance R. Cependant, on peut aussi utiliser des chaînes de diodes en série pour constituer ces dipôles. Il peut s'agir, par exemple, d'une chaîne de diodes constituées à partir de transistors NPN montés en direct ou en inverse ou encore d'une chaîne de diodes constituées à partir de transistors PNP montés en direct ou en inverse, conformément à la figure 3b. Comme cela est connu de l'homme de l'art, une chaîne de n diodes mises en série et parcourues par le courant II présente une impédance dynamique égale à n Ut/I1, où Ut est le potentiel thermodynamique mentionné précédemment. Cette impédance dynamique peut alors être relativement faible, favorisant par là même la rapidité de réponse du circuit.

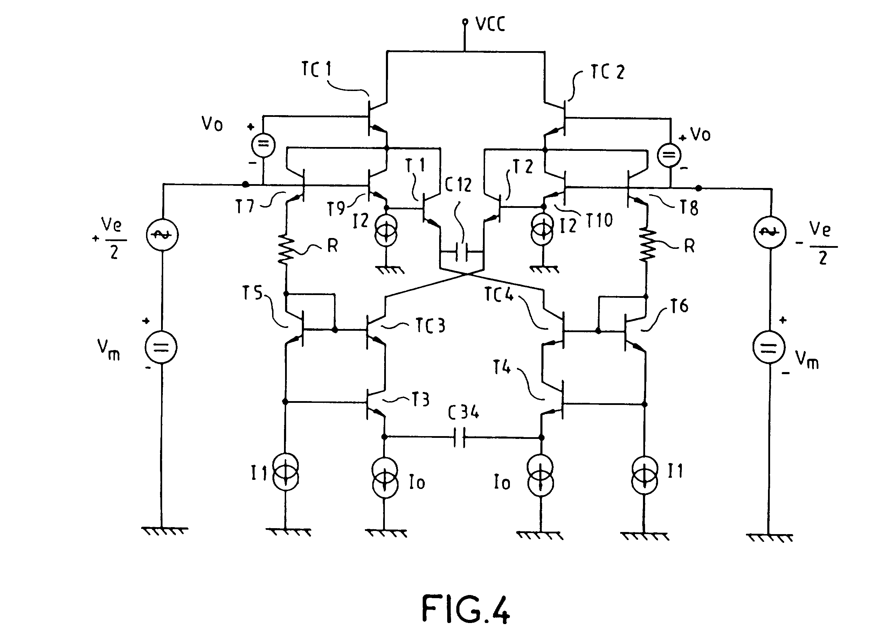

La figure 4 représente le schéma de l'échantillonneur-bloqueur de la figure 3a dans lequel a été apporté un premier perfectionnement.

Le schéma de la figure 4 reprend les éléments du schéma de la figure 3a. Il comprend deux transistors supplémentaires, T9 et T10, et deux générateurs de courant supplémentaires 12. La base du transistor T7 n'est alors plus reliée à la base du transistor T1 mais à la base d'un transistor T9 dont le collecteur est relié à l'émetteur du transistor TC1 et dont l'émetteur est relié d'une part à un générateur de courant 12 et d'autre part à la base du transistor T1.

De même, la base du transistor T8 n'est plus reliée à la base du transistor T2 mais à la base d'un transistor T10 dont le collecteur est relié à l'émetteur du transistor TC2 et dont l'émetteur est relié d'une part à un générateur de courant I2 et d'autre part à la base du transistor T2.

Un décalage temporel est alors introduit entre le signal appliqué à l'entrée de l'échantillonneur-bloqueur, maintenant représentée par les bases des transistors T9 et T10, et le signal appliqué sur les bases B1 et B2 des transistors T1 et T2. Selon l'invention, ce décalage temporel tend à compenser le décalage temporel induit par le dispositif de correction. L'efficacité de la correction se trouve alors améliorée du fait de la quasi simultanéité des variations des courants traversant T1 et T2 et provenant d'une part de C12 et d'autre part de TC3 et TC4.

Comme cela vient d'être décrit, l'invention permet l'amélioration de la non-linéarité des échantillonneurs-bloqueurs. Ainsi, à titre d'exemple, pour un signal Ve de 4 volts crête à crête, le taux de distorsion, en régime suiveur, d'un échantillonneur-bloqueur du type de celui décrit en figure 4 peut-il atteindre la valeur de - 75 dB à la fréquence de 50 MHz alors que, toutes choses égales par ailleurs, le taux de distorsion d'un échantillonneur-bloqueur selon l'art antérieur n'est que de - 50 dB à cette même fréquence.

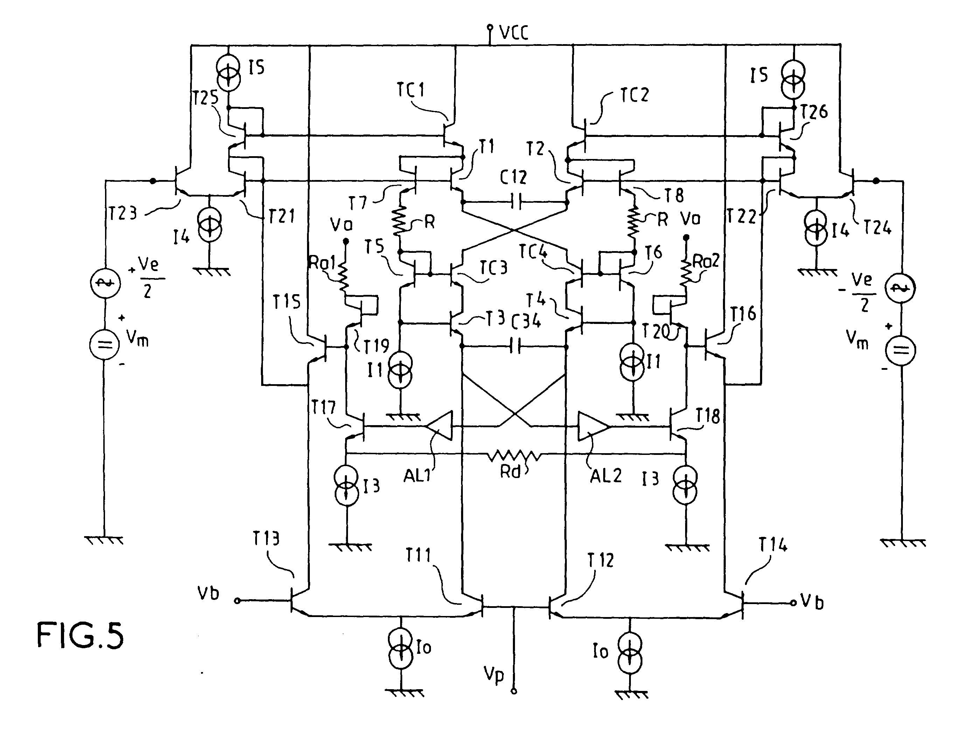

La figure 5 représente le schéma de l'échantillonneur-bloqueur de la figure 3 dans lequel a été apporté un deuxième perfectionnement.

Le schéma de la figure 5 reprend pour l'essentiel les éléments du schéma de la figure 3a.

Il comporte aussi des éléments supplémentaires permettant de diminuer le couplage parasite qui existe, à l'état bloqué, entre l'entrée et la sortie de l'échantillonneur-bloqueur.

Comme cela est connu de l'homme de l'art, ce couplage est dû aux capacités parasites base -émetteur que présentent les transistors T1 et T2 à l'état bloqué. Selon l'art antérieur, afin de pallier cet inconvénient, le signal appliqué sur la base B1 du transistor T1 est alors ramené sur l'émetteur E2 du transistor T2 par l'intermédiaire d'une première capacité C1 de valeur égale à la capacité base-émetteur du transistor T2 et le signal appliqué sur la base B2 du transistor T2 est ramené sur l'émetteur E1 du transistor T1 par l'intermédiaire d'une deuxième capacité C2 de valeur égale à la capacité base-émetteur du transistor T1. Les variations de tensions présentes à l'état bloqué aux bornes de la capacité C12 sont ainsi annulées par construction. A l'état passant, l'influence de ces capacités additionnelles est négligeable.

Cette solution est difficile à mettre en oeuvre du fait des faibles valeurs à affecter aux capacités C1 et C2. Les capacités utilisées sont alors des capacités MOS dont l'appariement avec les capacités de jonction qu'elles doivent compenser est difficile à réaliser.

L'invention ne présente pas cet inconvénient.

Selon l'invention, l'échantillonneur-bloqueur comprend des moyens permettant que la tension dynamique résiduelle appliquée sur les bases de T1 et T2 quand l'échantillonneur-bloqueur est bloqué soit atténuée par rapport aux variations de la tension Ve.

Ceci est obtenu en couplant les tensions variables d'entrée $+\frac{ve}{2}$ et $-\frac{ve}{2}$ aux transistors respectifs T1 et T2 par l'intermédiaire des interrupteurs respectifs T21 et T22, bloqués quand l'échantillonneur-bloqueur est bloqué, et en abaissant l'impédance dynamique sur les bases de T1 et T2. Ce changement de régime est obtenu en abaissant le potentiel statique appliquée aux bases des transistors T1 et T2, quand on passe en régime bloqué, d'une quantité égale sur chacune des bases, quelle que soit la valeur de la tension Ve mémorisée. Il en résulte alors l'avantage de diminuer la variation transitoire de la tension mémorisée lors du passage de l'état passant à l'état bloqué et réciproquement.

Les circuits permettant la diminution du potentiel sur les bases des transistors T1 et T2 interviennent dès le passage de l'état passant à l'état bloqué. Ainsi, afin de permettre une meilleure compréhension du fonctionnement de l'échantillonneur-bloqueur, le schéma de la figure 5 inclut-il les circuits de commande qui permettent de passer de l'état passant à l'état bloqué. Ces circuits de commande sont bien sûr présents quel que soit le type d'échantillonneur-bloqueur. S'ils n'ont pas été représentés sur les figures précédentes c'est pour des raisons de simplification, seul l'état passant de l'échantillonneur-bloqueur étant à prendre en compte alors.

Les circuits de commande sont constitués de quatre transistors T11, T12, T13 et T14.

L'émetteur du transistor T3 est relié au collecteur du transistor T11 dont l'émetteur est relié d'une part à un premier générateur de courant lo et d'autre part à l'émetteur du transistor T13 dont le collecteur est relié au circuit permettant de diminuer les couplages parasites et dont la base est reliée à une tension de commande Vb.

L'émetteur du transistor T4 est relié, quant à lui, au collecteur du transistor T12 dont l'émetteur est relié d'une part à un second générateur de courant lo et d'autre part à l'émetteur du transistor T14 dont le collecteur est relié au circuit permettant de diminuer les couplages parasites et dont la base est reliée à la même tension de commande Vb. Les bases des transistors T11 et T12 sont reliées à une même tension de commande Vp.

Quand la différence des tensions de commande Vb - Vp est négative, par exemple de l'ordre de -300 mV, les transistors T11 et T12 sont passants et les transistors T13 et T14 sont bloqués. Inversement, quand la différence des tensions de commande Vb - Vp est positive, par exemple supérieure ou égale à 300 mV, les transistors T13 et T14 sont passants, l'échantillonneur est bloqué et les circuits permettant de diminuer les couplages parasites sont activés. Les transistors T11 et T12 sont bloqués.

Selon le circuit de la figure 5, les tensions variables d'entrée $+\frac{ve}{2}$ et $-\frac{ve}{2}$ de même que les tensions de polarisation Vm de mode commun ne sont pas directement appliquées sur les bases B1 et B2.

Ainsi, le circuit d'accès de la tension variable d'entrée $+\frac{ve}{2}$ est-il constitué d'un transistor d'accès T23, de deux transistors T21 et T25 montés en diodes et deux générateurs de courant 14 et 15.

Le transistor T23 a sa base reliée à la tension variable d'entrée $+\frac{ve}{2}$, son collecteur relié à la tension d'alimentation + Vcc et son émetteur relié au générateur de courant 14.

Le transistor T21 a sa base reliée à la base du transistors T1, son émetteur relié au générateur de courant 14 et son collecteur relié à l'émetteur du transistor T25 dont la base est reliée à la base du transistor TC1 et dont le collecteur est relié à une bome du générateur de courant 15 dont l'autre bome est reliée à la tension d'alimentation + Vcc.

Comme cela a été mentionné précédemment, les transistors T21 et T25 sont montés en diodes. Ainsi, la base et le collecteur du transistor T21 d'une part, de même que la base et le collecteur du transistor T25 d'autre part sont-il reliés entre eux.

Le courant 15 sert à polariser la diode T21 à l'état passant. De façon préférentielle la valeur du courant 15 est égale à la moitié de celle du courant 14. Le transistor T25, quant à lui, sert à indexer sur le transistor de type "cascode" TC1 les variations de tension qui apparaissent sur le transistor T1.

Un circuit du même type que celui qui vient d'être décrit pour le circuit d'accès de la tension variable d'entrée $+\frac{ve}{2}$ existe pour l'accès de la tension variable d'entrée $\frac{ve}{2}$.

Ce circuit présente la même configuration que le circuit décrit ci-dessus et comprend, outre deux générateurs de courant 14 et 15, les transistors T24, T22 et T26 lesquels correspondent aux transistors respectifs précédents T23, T21 et T25.

Comme cela a été mentionné précédemment, les circuits permettant de diminuer les couplages parasites sont activés quand l'échantillonneur-bloqueur est à l'état bloqué.

A l'état bloqué, les transistors T13 et T14 sont passants. Le transistor T13 a son collecteur relié à l'émetteur d'un transistor T15 dont le collecteur est relié à la tension d'alimentation + Vcc et le transistor T14 a son collecteur relié à l'émetteur d'un transistor T16 dont le collecteur est aussi relié à la tension d'alimentation + Vcc. Ainsi, lorsque les transistors T13 et T14 conduisent, les transistors T15 et T16 conduisent-ils aussi entraînant une diminution du potentiel présent sur leurs émetteurs. Les transistors T15 et T16 ayant leurs émetteurs respectivement reliés aux bases des transistors T1 et T2, il s'en suit que les tensions appliquées aux bases des transistors T1 et T2 diminuent aussi. La diminution de tension qui s'opère sur les bases des transistors T1 et T2 conduit alors au blocage des diodes T21 et T22 et conjointement à l'abaissement des impédances sur les bases de T1 et T2 par mise en conduction des transistors T15 et T16.

Selon l'invention, les tensions appliquées sur les bases des transistors T15 et T16 sont choisies suffisamment basses pour garantir le blocage des diodes T21 et T22 même pour les signaux variables d'entrée minima de la gamme de fonctionnement.

Le circuit permettant d'appliquer la tension de base du transistor T15 comprend une résistance Ra1, un transistor T19 monté en diode, un transistor T17, un générateur de courant 13 et un amplificateur de lecture AL1.

De même, le circuit permettant d'appliquer la tension de base du transistor T16 comprend une résistance Ra2, choisie préférentiellement de valeur égale à celle de la résistance Ra1, un transistor T20 monté en diode, un transistor T18, un générateur de courant 13 et un amplificateur de lecture AL2.

Les transistors T17 et T18 constituent un amplificateur différentiel de gain unitaire, dégénéré par une résistance Rd reliant leurs émetteurs et dont la valeur est préférentiellement le double de la valeur de la résistance Ra1.

La base du transistor T15 est reliée d'une part à l'émetteur du transistor T19 et d'autre part au collecteur du transistor T17. Le transistor T19 a sa base reliée à son collecteur, lequel est relié à une première borne de la résistance Ra1 dont une deuxième borne est reliée à la tension Va.

Le transistor T17 a son émetteur relié au générateur de courant 13 et sa base reliée à la sortie de l'amplificateur de lecture AL1 dont l'entrée est reliée à l'émetteur du transistor T4. L'amplificateur de lecture AL1 est un amplificateur tampon d'impédance d'entrée très élevée et de gain unitaire.

Le circuit permettant d'appliquer la tension de base du transistor T16 est constitué de composants du même type que le circuit permettant d'appliquer la tension de base du transistor T15. Comme le représente la figure 5, l'architecture des deux circuits est identique : le transistor T18 joue le rôle du transistor T17, le transistor T20 celui du transistor T19, l'amplificateur de lecture AL2 celui de l'amplificateur de lecture AL1.

Selon l'invention, la différence de potentiel appliquée sur les bases des transistors T15 et T16 est donc indexée sur la tension mémorisée aux bornes de la capacité C34. Il vient :

$$VC34 = VE3 - VE4 = VB15 - VB16$$

Il s'en suit que les variations qui affectent le potentiel de base des transistors T1 et T2 lors du passage de l'état passant à l'état bloqué sont quasiment égales. Les variations de la tension de sortie de l'échantillonneur-bloqueur lors du transitoire de l'état passant à l'état bloqué se trouvent alors avantageusement minimisé.

Comme cela a été mentionné précédemment, les tensions appliquées sur les bases des transistors T15 et T16 sont choisies suffisamment basses pour garantir le blocage des diodes T21 et T22 même pour les signaux variables minima de la gamme de fonctionnement. Le potentiel de mode commun Va est alors choisi en conséquence.

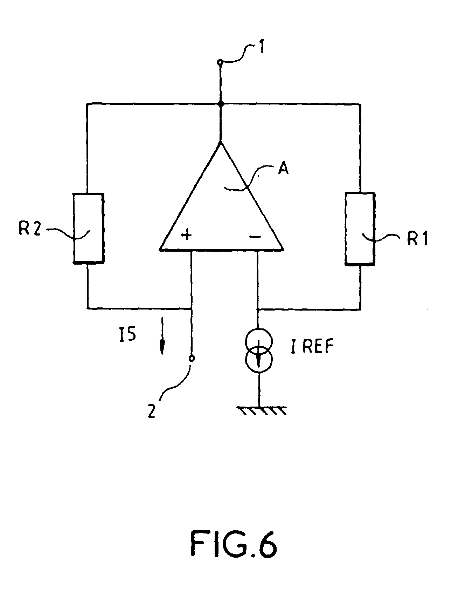

Comme cela apparaît sur la figure 5, les générateurs de courant 15 sont de type positif. Le potentiel présent sur leur sortie, c'est-à-dire là où est connectée leur charge, est inférieur à leur potentiel de référence + Vcc. Ils sont alors réalisés soit à l'aide d'un transistor PNP, comme cela est connu de l'homme de l'art, soit à l'aide d'un circuit tel que celui représenté en figure 6.

Le schéma de la figure 6 représente une alternative au générateur de courant 15 à transistors PNP.

Il comprend deux résistances R1 et R2, un générateur de courant Iref et un amplificateur différentiel A réalisé à base de transistors NPN.

La résistance R2 relie l'entrée sans inversion 2 de l'amplificateur A à la sortie 1 dudit amplificateur et la résistance R1 relie l'entrée avec inversion de l'amplificateur A à ladite sortie 1. Le générateur de courant Iref est placé entre l'entrée avec inversion et la masse. Il vient donc :

$$I5 = Iref \times R1/R2.$$

Le circuit de la figure 6 représente le générateur de courant 15. La sortie 1 de l'amplificateur A est la borne du générateur de courant 15 reliée à la tension d'alimentation + Vcc et l'entrée sans inversion de l'amplificateur A est la borne du générateur de courant 15 reliée au collecteur du transistor T25.

Avantageusement l'amplificateur A est un amplificateur réalisé en technologie rapide tout NPN tel que celui décrit dans la demande de brevet français déposée le 21 novembre 1991 au nom de la Société Thomson Composants Militaires et Spatiaux sous le N° d'enregistrement national 91 14406.

Les figures 4 et 5 représentent séparément deux perfectionnements apportées à l'échantillonneur-bloqueur selon l'invention. Il est évident que l'invention conceme aussi un circuit contenant simultanément ces deux perfectionnements.

## Revendications

1. Echantillonneur-bloqueur différentiel comprenant un premier et un second transistors (T1 et T2) commandés de façon à être rendus passants ou bloqués, le signal de sortie de l'échantillonneur-bloqueur étant récupéré aux bornes d'une capacité de sortie (C12) reliant les émetteurs (E1, E2) desdits transistors, caractérisé en ce qu'il comprend des moyens pour rendre constant le courant (Io) qui traverse les transistors à l'état passant, pendant les phases d'échantillonnage, malgré les variations de courant dans la capacité de sortie (C12).

2. Echantillonneur-bloqueur selon la revendication 1, caractérisé en ce que lesdits moyens sont constitués de deux générateurs de courant dynamiques (T3,T4) et d'une capacité (C34), les deux générateurs de courant dynamiques étant modulés par un courant différentiel issu de ladite capacité (C34) et dont les variations reproduisent, avec un signe opposé, les variations de courant qui apparaissent dans la capacité de sortie (C12).

3. Echantillonneur-bloqueur selon la revendication 2, caractérisé en ce qu'un premier des deux générateurs de courant dynamique est constitué d'un troisième transistor (T3) dont le collecteur est relié à l'émetteur (E2) du deuxième transistor (T2) par l'intermédiaire d'un premier transistor de type "cascode" (TC3) et dont l'émetteur est relié à un premier générateur de courant constant (Io), ledit premier générateur de courant dynamique étant modulé par un premier circuit de modulation comprenant un premier transistor monté en diode (T5) dont la base est reliée à son collecteur ainsi qu'à la base dudit premier transistor de type "cascode" (TC3), et dont l'émetteur est relié à la base dudit troisième transistor (T3) et à un deuxième générateur de courant

constant (Io), le collecteur dudit premier transistor monté en diode (T5) étant relié au premier transistor (T1) par des premiers moyens de façon que le courant parcourant ledit troisième transistor (T3) soit modulé au rythme du signal appliqué sur la base (B1) du premier transistor (T1), et en ce qu'un second des deux générateurs de courant dynamique est constitué d'un quatrième transistor (T4) dont le collecteur est relié à l'émetteur (E1) du premier transistor (T1) par l'intermédiaire d'un second transistor de type "cascode" (TC4) et dont l'émetteur est relié à un troisième générateur de courant constant (Io), ledit second générateur de courant dynamique étant modulé par un second circuit de modulation comprenant un second transistor monté en diode (T6), dont la base est reliée à son collecteur ainsi qu'à la base du second transistor de type "cascode" (TC4), et dont l'émetteur est relié à la base dudit quatrième transistor (T4) et à un quatrième générateur de courant constant (Io), le collecteur dudit second transistor monté en diode (T6) étant relié au deuxième transistor (T2) par des seconds moyens de façon que le courant parcourant ledit quatrième transistor (T4) soit modulé au rythme du signal appliqué sur la base (B2) du deuxième transistor (T2).

4. Echantillonneur-bloqueur selon la revendication 3, caractérisé en ce que lesdits premiers moyens sont constitués d'un premier dipôle (D1) reliant le collecteur dudit premier transistor monté en diode (T5) à la base (B1) du premier transistor (T1) et en ce que lesdits seconds moyens sont constitués d'un second dipôle (D2) identique au premier dipôle (D1) et reliant le collecteur dudit second transistor monté en diode (T6) à la base (B2) du deuxième transistor (T2).

5. Echantillonneur-bloqueur selon la revendication 3, caractérisé en ce que lesdits premiers moyens sont constitués d'un premier dipôle (D1) reliant le collecteur dudit premier transistor monté en diode (T5) à l'émetteur d'un transistor (T7) dont la base et le collecteur sont respectivement reliés à la base et au collecteur du premier transistor (T1) et en ce que lesdits seconds moyens sont constitués d'un second dipôle (D2) reliant le collecteur dudit second transistor monté en diode (T6) à l'émetteur d'un transistor (T8) dont la base et le collecteur sont respectivement reliés à la base et au collecteur du deuxième transistor (T2).

6. Echantillonneur-bloqueur selon la revendication 3, caractérisé en ce que lesdits premiers moyens sont constitués d'un premier dipôle (D1) reliant le collecteur dudit premier transistor monté en diode (T5) à l'émetteur d'un transistor (T7) dont la base est reliée à la base d'un premier transistor supplémentaire (T9) et dont le collecteur est relié au collecteur du premier transistor (T1), l'émetteur dudit premier transistor supplémentaire (T9) étant relié à un générateur de courant (I2) et à la base du premier transistor (T1), et en ce que lesdits seconds moyens sont constitués d'un second dipôle (D2) reliant le collecteur dudit second transistor monté en diode (T6) à l'émetteur d'un transistor (T8) dont la base est reliée à la base d'un second transistor supplémentaire (T10) et dont le collecteur est relié au collecteur du deuxième transistor (T2), l'émetteur dudit second transistor supplémentaire (T10) étant relié à un générateur de courant (I2) et la base du deuxième transistor (T2).

7. Echantillonneur-bloqueur selon l'une quelconque des revendications 3 à 6, caractérisé en ce qu'il comprend des moyens permettant de réduire, en mode bloqué, l'amplitude du signal dynamique

$$\left( \pm \frac{Ve}{2} \right)$$

appliqué sur les bases des premier et second transistors (T1 et T2), en abaissant d'une même quantité le potentiel statique de ces bases, quelle que soit ladite amplitude.

8. Echantillonneur-bloqueur selon la revendication 7, caractérisé en ce que les moyens permettant de réduire en mode bloqué, l'amplitude du signal dynamique appliqué sur les bases des premier et deuxième transistors (T1 et T2) comprennent un cinquième transistor (T15) qui conduit à l'état bloqué de l'échantillonneur-bloqueur, dont l'émetteur est relié à la base du premier transistor (T1) et dont la base est reliée à un premier circuit de commande délivrant une tension indexée sur la tension recueillie sur l'émetteur dudit quatrième transistor (T4), et un sixième transistor (T16) qui conduit à l'état bloqué de l'échantillonneur-bloqueur, dont l'émetteur est relié à la base du deuxième transistor (T2) et dont la base est reliée à un deuxième circuit de commande délivrant une tension indexée sur la tension recueillie sur l'émetteur dudit troisième transistor (T3).

9. Echantillonneur-bloqueur selon la revendication 8, caractérisé en ce que ledit premier circuit de commande est composé d'un premier amplificateur tampon (AL1) dont l'entrée est reliée à l'émetteur dudit quatrième transistor (T4) et dont la sortie est reliée à la base d'un transistor (T17) dont l'émetteur est relié à un générateur de courant (I3) et dont le collecteur est relié d'une part à la base dudit cinquième transistor (T15) qui conduit à l'état bloqué de l'échantillonneur-bloqueur et, d'autre part, à l'émetteur d'un troisième transistor monté en diode (T19) dont la base est reliée à son collecteur lequel est relié par une résistance (Ra1) à une tension continue (Va), et en ce que ledit deuxième circuit de commande est composé d'un deuxième amplificateur tampon (AL2) dont l'entrée est reliée à l'émetteur dudit troisième transistor (T3) et dont la sortie est reliée à la base d'un transistor (T18) dont l'émetteur est relié à un générateur de courant (I3) et dont le collecteur est relié d'une part à la base dudit sixième transistor (T16) qui conduit à l'état bloqué de l'échantillonneur-bloqueur et, d'autre part, à l'émetteur d'un quatrième transistor monté en diode (T20) dont la base est reliée à son collecteur, lequel est relié par une résistance (Ra2) à ladite tension continue (Va), les émetteurs des transistors (T17, T18) dont les bases sont reliées aux sorties des amplificateurs tampon (AL1,AL2) étant reliés entre eux par une résistance (Rd).

10. Echantillonneur-bloqueur selon la revendication 9, caractérisé en ce que la base (B1) du premier transistor (T1) est reliée à la base d'un cinquième transistor monté en diode (T21) et en ce que la base (B2) du second transistor (T2) est reliée à la base d'un sixième transistor monté en diode (T22).

11. Echantillonneur-bloqueur selon l'une quelconque des revendications 4 à 10, caractérisé en ce que les dipôles (D1, D2) sont réalisés à l'aide d'une résistance.

12. Echantillonneur-bloqueur selon l'une quelconque des reve-ndications 4 à 10, caractérisé en ce que les dipôles (D1, D2) sont réalisés par un ensemble de diodes montées en série.

**Patentansprüche**

1. Differentielle Tast- und Halteschaltung mit einem ersten und einem zweiten Transistor (T1, T2), die leitend oder nichtleitend gesteuert werden können, wobei das Ausgangssignal der Tast- und Halteschaltung an den Klemmen eines Ausgangskondensators (C12) abgenommen werden kann, der die Emitter (El, E2) dieser Transistoren verbindet, dadurch gekennzeichnet, daß sie Mittel aufweist, um den Strom (Io) durch die Transistoren in deren leitendem Zustand während der Tastphasen trotz der Schwankungen des Stroms im Ausgangskondensator (C12) konstant zu machen.

2. Tast- und Halteschaltung nach Anspruch 1, dadurch gekennzeichnet, daß die Mittel aus zwei dynamischen Stromgeneratoren (T3, T4) und einem Kondensator (C34) bestehen, wobei die beiden dynamischen Stromgeneratoren durch einen Diferentialstrom moduliert werden, der aus dem Kondensator (C34) kommt und dessen Schwankungen mit entgegengesetztem Vorzeichen die Schwankungen des Stroms reproduzieren, die im Ausgangskondensator (C12) auftreten.

3. Tast- und Halteschaltung nach Anspruch 2, dadurch gekennzeichnet, daß ein erster der beiden dynamischen Stromgeneratoren von einem dritten Transistor (T3) gebildet wird, dessen Kollektor an den Emitter (E2) des zweiten Transistors (T2) über einen ersten Kaskode-Transistor (TC3) angeschlossen ist und dessen Emitter mit einem ersten Konstantstromgenerator (Io) verbunden ist, wobei der erste dynamische Stromgenerator durch eine erste Modulationsschaltung moduliert wird, die einen ersten als Diode geschalteten Transistor (T5) enthält, dessen Basis mit seinem eigenem Kollektor sowie mit der Basis des ersten Kaskodetransistors (TC3) verbunden ist und dessen Emitter an die Basis des dritten Transistors (T3) und an einen zweiten Konstantstromgenerator (I1) angeschlossen ist, wobei der Kollektor des ersten als Diode geschalteten Transistors (T5) an den ersten Transistor (T1) über erste Mittel so angeschlossen ist, daß der durch den dritten Transistor (T3) fließende Strom im Rhythmus des an die Basis (B1) des ersten Transistors (T1) angelegten Signals moduliert wird, und daß ein zweiter der beiden dynamischen Stromgeneratoren von einem vierten Transistor (T4) gebildet wird, dessen Kollektor an den Emitter (E1) des ersten Transistors (T1) über einen zweiten Kaskode-Transistor (TC4) angeschlossen ist und dessen Emitter mit einem dritten Konstantstromgenerator (Io) verbunden ist, wobei der zweite dynamische Stromgenerator durch eine zweite Modulationsschaltung moduliert wird, die einen zweiten als Diode geschalteten Transistor (T6) enthält, dessen Basis mit seinem eigenem Kollektor sowie mit der Basis des zweiten Kaskodetransistors (TC4) verbunden ist und dessen Emitter an die Basis des vierten Transistors (T4) und an einen vierten Konstantstromgenerator (I1) angeschlossen ist, wobei der Kollektor des zweiten als Diode geschalteten Transistors (T6) an den zweiten Transistor (T2) über zweite Mittel so angeschlossen ist, daß der durch den vierten Transistor (T4) fließende Strom im Rhythmus des an die Basis (B2) des zweiten Transistors (T2) angelegten Signals moduliert wird.

4. Tast- und Halteschaltung nach Anspruch 3, dadurch gekennzeichnet, daß die ersten Mittel von einem ersten Dipol (D1) gebildet werden, der den Kollektor des ersten als Diode geschalteten Transistors (T5) mit der Basis (B1) des ersten Transistors (T1) verbindet, und daß die zweiten Mittel von einem zweiten, dem ersten Dipol (D1) gleichenden Dipol (D2) gebildet werden, der den Kollektor des zweiten als Diode geschalteten Transistors (T6) mit der Basis (B2) des zweiten Transistors (T2) verbindet.

5. Tast- und Halteschaltung nach Anspruch 3, dadurch gekennzeichnet, daß die ersten Mittel von einem ersten Dipol (D1) gebildet werden, der den Kollektor des ersten als Diode geschalteten Transistors (T5) mit dem Emitter eines Transistors (T7) verbindet, dessen Basis- und Kollektorelektroden an die Basis bzw. den Kollektor des ersten Transistors (T1) angeschlossen sind, und daß die zweiten Mittel von einem zweiten Dipol (D2) gebildet werden, der den Kollektor des zweiten als Diode geschalteten Transistors (T6) mit dem Emitter eines Transistors (T8) verbindet, dessen Basis- und Kollektorelektroden an die Basis bzw. den Kollektor des zweiten Transistors (T2) angeschlossen sind.

6. Tast- und Halteschaltung nach Anspruch 3, dadurch gekennzeichnet, daß die ersten Mittel von einem ersten Dipol (D1) gebildet werden, der den Kollektor des ersten als Diode geschalteten Transistors (T5) mit dem Emitter eines Transistors (T7) verbindet, dessen Basis an die Basis eines ersten zusätzlichen Transistors (T9) angeschlossen ist und dessen Kollektor mit dem Kollektor des ersten Transistors (T1) verbunden ist, wobei der Emitter des ersten zusätzlichen Transistors (T9) an einen Stromgenerator (I2) und an die Basis des ersten Transistors (T1) angeschlossen ist, und daß die zweiten Mittel von einem zweiten Dipol (D2) gebildet werden, der den Kollektor des zweiten als Diode geschalteten Transistors (T6) mit dem Emitter eines Transistors (T8) verbindet, dessen Basis an die Basis eines zweiten zusätzlichen Transistors (T10) angeschlossen ist und dessen Kollektor mit dem Kollektor des zweiten Transistors (T2) verbunden ist, wobei der Emitter des zweiten zusätzlichen Transistors (T10) an einen Stromgenerator (I2) und an die Basis des zweiten Transistors (T2) angeschlossen ist.

7. Tast- und Halteschaltung nach einem beliebigen der Ansprüche 3 bis 6, dadurch gekennzeichnet, daß Mittel vorgesehen sind, um in der Haltephase die Amplitude des an die Basiselektroden des ersten und des zweiten Transistors (T1, T2) angelegten dynamischen Signals ($\pm$Ve/2) verringern zu können, indem das statische Potential dieser Basiselektroden um einen gleichen Betrag unabhängig von der erwähnten Amplitude abgesenkt wird.

8. Tast- und Halteschaltung nach Anspruch 7, dadurch gekennzeichnet, daß die Mittel, mit denen die Amplitude des an die Basiselektroden des ersten und des zweiten Transistors (T1, T2) angelegten dynamischen Signals in der Haltephase verringert werden kann, einen fünften Transistor (T15), der in der Haltephase der Tast- und Halteschaltung leitend ist, dessen Emitter mit der Basis des ersten Transistors (T1) und dessen Basis mit einer ersten Steuerschaltung verbunden ist, die eine auf die am Emitter des vierten Transistors (T4) entnommene Spannung indexierte Spannung liefert, und einen sechsten Transistor (T16) enthalten, der in der Haltephase der Tast- und Halteschaltung leitend ist, dessen Emitter an die Basis des zweiten Transistors (T2) und dessen Basis an eine zweite Steuerschaltung angeschlossen ist, die eine Spannung liefert, die auf die am Emitter des dritten Transistors (T3) abgenommene Spannung indexiert ist.

9. Tast- und Halteschaltung nach Anspruch 8, dadurch gekennzeichnet, daß die erste Steuerschaltung von einem ersten Pufferverstärker (AL1) gebildet wird, dessen Eingang an den Emitter des vierten Transistors (T4) angeschlossen ist und dessen Ausgang mit der Basis eines Transistors (T17) verbunden ist, dessen Emitter an einen Stromgenerator (I3) und dessen Kollektor einerseits an die Basis des fünften Transistors (T15), der in der Haltephase der Tast- und Halteschaltung leitend ist, und andrerseits an den Emitter eines dritten als Diode geschalteten Transistors (T19) angeschlossen ist, dessen Basis mit seinem Kollektor verbunden ist, der wiederum über einen Widerstand (Ral) eine Gleichspannung (Va) empfängt, und daß die zweite Steuerschaltung von einem zweiten Pufferverstärker (AL2) gebildet wird, dessen Eingang an den Emitter des dritten Transistors (T3) angeschlossen ist und dessen Ausgang mit der Basis eines Transistors (T18) verbunden ist, dessen Emitter an einen Stromgenerator (I3) und dessen Kollektor einerseits an die Basis des sechsten Transistors (T16), der in dervHaltephase der Tast- und Halteschaltung leitend ist, und andrerseits an den Emitter eines vierten als Diode geschalteten Transistors (T20) angeschlossen ist, dessen Basis mit seinem Kollektor verbunden ist, der wiederum über einen Widerstand (Ra2) die Gleichspannung (Va) empfängt, wobei die Emitter der Transistoren (T17, T18), deren Basiselektroden an die Ausgänge der Pufferverstärker (AL1, AL2) angeschlossen sind, miteinander über einen Widerstand (Rd) verbunden sind.

10. Tast- und Halteschaltung nach Anspruch 9, dadurch gekennzeichnet, daß die Basis (B1) des ersten Transistors (T1) an die Basis eines fünften als Diode geschalteten Transistors (T21) angeschlossen ist und daß die Basis (B2) des zweiten Transistors ((T2) mit der Basis eines sechsten als Diode geschalteten Transistors (T22) verbunden ist.

11. Tast-und Halteschaltung nach einem beliebigen der Ansprüche 4 bis 10, dadurch gekennzeichnet, daß die Dipole (D1, D2) in Form eines Widerstands realisiert sind.

12. Tast-und Halteschaltung nach einem beliebigen der Ansprüche 4 bis 10, dadurch gekennzeichnet, daß die Dipole (D1, D2) durch eine Serienschaltung von Dioden gebildet werden.

## Claims

1. Differential sample-and-hold circuit comprising a first and second transistor (T1 and T2) which are controlled so as to be turned on or off, the output signal of the sample-and-hold circuit being recovered at the terminals of an output capacitor (C12) connecting the emitters (E1, E2) of the said transistors, characterized in that it comprises means for making the current (Io) flowing through the transistors constant when they are on, during the sampling phases, in spite of the current variations in the output capacitor (C12).

2. Sample-and-hold circuit according to Claim 1, characterized in that the said means consist of two dynamic current generators (T3, T4) and a capacitor (C34), the two dynamic current generators being modulated by a differential current which is output by the said capacitor (C34) and the variations in which reproduce the current variations which appear in the output capacitor (C12).

3. Sample-and-hold circuit according to Claim 2, characterized in that a first of the two dynamic current generators consists of a third transistor (T3) whose collector is connected to the emitter (E2) of the second transistor (T2) via a first transistor (TC3) of the "cascode" type and whose emitter is connected to a first current generator (Io), the said first dynamic current generator being modulated by a first modulation circuit comprising a first transistor (T5) connected in diode mode, the base of which is connected to its collector as well as to the base of the said first transistor (TC3) of the "cascode" type, and the emitter of which is connected to the base of the said third transistor (T3) and to a second current generator (I1), the collector of the said first transistor (T5) connected in diode mode being connected to the first transistor (T1) via first means so that the current flowing through the said third transistor (T3) is modulated at the frequency of the signal applied to the base (B1) of the first transistor (T1), and in that a second of the two dynamic current generators consists of a fourth transistor (T4) whose collector is connected to the emitter (EI) of the first transistor (T1) via a second transistor (TC4) of the "cascode" type and whose emitter is connected to a third current generator (Io), the said second dynamic current being modulated by a second modulation circuit comprising a second transistor (T6) connected in diode mode, the base of which is connected to its collector as well as to its base of the second transistor (TC4) of the "cascode" type, and the emitter of which is connected to the base of the said fourth transistor (T4) and to a fourth constant-current generator (I1), the collector of the said second transistor (T6) connected in diode mode being connected to the second transistor (T2) via second means so that the current flowing through the said fourth transistor (T4) is modulated at the frequency of the signal applied to the base (B2) of the second transistor (T2).

4. Sample-and-hold circuit according to Claim 3, characterized in that the said first means consist of a first dipole (D1) connecting the collector of the said first transistor (T5) connected in diode mode to the base (B1) of the first transistor (T1) and in that the said second means consist of a second dipole (D2), identical to the first dipole (D1) and connecting the collector of the said second transistor (T6) connected in diode mode to the base (B2) of the second transistor (T2).

5. Sample-and-hold circuit according to Claim 3, characterized in that the said first means consist of a first dipole (D1) connecting the collector of the said first transistor (T5) connected in diode mode to the emitter of a transistor (T7) whose base and collector are respectively connected to the base and to the collector of the first transistor (T1) and in that the said second means consist of a second dipole (D2) connecting the collector of the said second transistor (T6) connected in diode mode to the emitter of a transistor (T8) whose base and collector are respectively connected to the base and to the collector of the second transistor (T2).

6. Sample-and-hold circuit according to Claim 3, characterized in that the said first means consist of a first dipole (D1) connecting the collector of the said first transistor (T5) connected in diode mode to the emitter of a transistor (T7) whose base is connected to the base of a first additional transistor (T9) and whose collector is connected to the collector of the first transistor (T1), the emitter of the said first additional transistor (T9) being connected to a current generator (I2) and to the base of the first transistor (T1), and in that the said second means consist of a second dipole (D2) connecting the collector of the said second transistor (T6) connected in diode mode to the emitter of a transistor (T8) whose base is connected to the base of a second additional transistor (T10) and whose collector is connected to the collector of the second transistor (T2), the emitter of the said second additional transistor (T10) being connected to a current generator (I2) and the base of the second transistor (T2).

7. Sample-and-hold circuit according to any one of Claims 3 to 6, characterized in that it comprises means making it possible to reduce, in off mode, the amplitude of the dynamic signal ($\pm \frac{Ve}{2}$), applied to the bases of the first and second transistors (T1 and T2), by lowering the static potential of these bases by the same amount, regardless of the said amplitude.

8. Sample-and-hold circuit according to Claim 7, characterized in that the means making it possible for the potential making it possible to reduce, in off mode, the amplitude of the dynamic signal applied to the bases of the first and second transistors (T1 and T2) comprise a fifth transistor (T15) which is on when the sample-and-hold circuit is off, the emitter of which is connected to the base of the first transistor (T1) and the base of which is connected to a first control circuit delivering a voltage indexed to the voltage collected from the emitter of the said fourth transistor (T4), and a sixth transistor (T16) which is on when the sample-and-hold circuit is off, the emitter of which is connected to the base of the second transistor (T2) and the base of which is connected to a second control circuit delivering a voltage indexed to the voltage collected from the emitter of the said third transistor (T3).

9. Sample-and-hold circuit according to Claim 8, characterized in that the said first control circuit is composed of a first buffer amplifier (AL1) whose input is connected to the emitter of the said fourth transistor (T4) and whose output is connected to the base of a transistor (T17) whose emitter is connected to a current generator (I3) and whose collector is connected, on the one hand, to the base of the said fifth transistor (T15) which is on when the sample-and-hold circuit is off and, on the other hand, to the emitter of a third transistor (T19) connected in diode mode whose base is connected to its collector which is connected via a resistor (Ra1) to a DC voltage (Va), and in that the said second control circuit is composed of a second buffer amplifier (AL2) whose input is connected to the emitter of the said third transistor (T3) and whose output is connected to the base of a transistor (T18) whose emitter is connected to a current generator (I3) and whose collector is connected, on the one hand, to the base of the said sixth transistor (T16) which is on when the sample-and-hold circuit is off and, on the other hand, to the emitter of a fourth transistor (T20) connected in diode mode whose base is connected to its collector, which is connected via a resistor (Ra2) to the said DC voltage (Va), the emitters of the transistors (T17, T18) whose bases are connected to the outputs of the buffer amplifiers (AL1, AL2) being connected together via a resistor (Rd).

10. Sample-and-hold circuit according to Claim 9, characterized in that the base (B1) of the transistor (T1) is connected to the base of a fifth transistor (T21) connected in diode mode and in that the base (B2) of the second transistor T2 is connected to the base of a sixth transistor (T22) connected in diode mode.

11. Sample-and-hold circuit according to any one of Claims 4 to 10, characterized in that the dipoles (D1, D2) are made using a resistor.

12. Sample-and-hold circuit according to any one of Claims 4 to 10, characterized in that the dipoles (D1, D2) are made using a set of diodes connected in series.

FIG.1

EP 0 750 782 B1

FIG.2

EP 0 750 782 B1

FIG.3a

FIG.3b

FIG.4

**FIG.5**

FIG.6